# EUROPÄISCHE PATENTANMELDUNG

(11) **EP 4 556 601 A1**
(43) Veröffentlichungstag der Anmeldung: **21.05.2025**
(21) Anmeldenummer: 23210484.4
(22) Anmeldetag: 17.11.2023
(51) Int. Cl.: C30B 15/00, C30B 35/00

(54) **VERFAHREN ZUM AUSBAU EINES STABES AUS EINER KRISTALLZIEHANLAGE**

(71) Anmelder: Siltronic AG, 81677 München (DE)
(72) Erfinder: Furtner, Kurt, 4962 Mining (AT); Huber, Johann-Andreas, 83404 Ainring (DE); Kern, Alois, 84558 Kirchweidach (DE)

(57) **Zusammenfassung**

Verfahren zum Ausbauen eines Kristalls aus einer Kristallziehanlage nach Czochralski umfassend folgende Schritte in gegebener Reihenfolge: (a) Ziehen eines Kristalls in einer Ziehanlage nach Czochralski aus einer Kristallwachstumskammer in eine Kristallziehkammer, beinhaltend das Ziehen eines Dünnhalses, (b) Abkühlen des gezogenen Kristalls in der Kristallziehkammer, (c) Trennen der Kristallziehkammer von der Kristallwachstumskammer durch Lösen der Verbindung zwischen Kristallziehkammer und Kristallwachstumskammer und Verfahren der Kristallziehkammer nach oben, (d) horizontales Schwenken der Kristallziehkammer bis zu einer Endposition, so dass eine Kristalltransporteinheit den Kristall aufnehmen kann, (e) Senken des Kristalls aus der Kristallziehkammer in die Kristalltransporteinheit, (f) Trennen des Kristalls am Dünnhals.

## Beschreibung

Die Erfindung bezieht sich auf eine Vorrichtung zum Ausbau eines monokristallinen Stabes aus Halbleitermaterial aus einer Kristallziehanlage.

Das Züchten von Kristallen ist eine wichtige Vorstufe zur Herstellung von Halbleiterbauelementen. Halbleiterkristallzuchtverfahren wurden verbessert, um einkristalline Halbleiterblöcke zu erhalten, die beispielsweise einen Durchmesser von 200 mm bis 300 mm und eine Länge von mehr als zwei Metern haben können.

Verschiedene im Handel erhältliche Modelle von Kristallzuchtöfen, die die gängigen Kristallzuchtverfahren unterstützen, sind funktionell und strukturell ähnlich. Ein typischer Kristallzüchtungsofen verfügt über eine Kristallwachstumskammer im Boden des Ofens. In der Kristallwachstumskammer befinden sich in der Regel ein Tiegel, Heizelemente zum Einschmelzen und Aufrechterhalten der Schmelze einer in den Tiegel eingebrachten Charge eines kristallinen Materials sowie Mechanismen zum Drehen des Tiegels, um die Gleichmäßigkeit des Wärmeflusses in der Schmelze während des Kristallzuchtprozesses zu steuern.

Über der Kristallwachstumskammer erhebt sich eine aufragende Struktur einer Kristallziehkammer. Die Kristallziehkammer ist in der Regel ein aufrechtes, im Wesentlichen zylindrisches Gehäuse, das in einer oberen Struktur eines Kristallziehmechanismus endet. Die Kristallwachstumskammer und die Kristallziehkammer stehen während des Wachstumsprozesses miteinander in Verbindung. Während ein monokristalliner Stab aus der Schmelze in der Kristallwachstumskammer weiter wächst, hebt der Kristallziehmechanismus den Stab mit einer definierten Geschwindigkeit in die Kristallziehkammer.

In der Regel entnimmt ein Bediener den gezüchteten Stab aus dem beschriebenen Ofen durch eine seitliche Zugangstür in der Kristallziehkammer. Eine Öffnung zwischen der Kristallzuchtkammer und der Kristallziehkammer kann geschlossen werden, während die normalerweise hermetisch verschlossene seitliche Zugangstür der Ziehkammer offenbleibt.

Die Entnahme von monokristallinen Stäben aus Züchtungsöfen hat in der Vergangenheit Probleme bereitet, da die schweren und heißen Stäbe bei der Entnahme beschädigt oder aber im schlimmsten Fall abstürzen und so eine Gefahr für Mensch und Equipment darstellen können.

Im Stand der Technik finden sich einige Ansätze, wie monokristalline Stäbe aus Kristallziehanlagen entnommen werden können.

Das chinesische Gebrauchsmuster CN 21 597 162 3 U offenbart eine Vorrichtung zur Entnahme von Stäben aus einer Kristallziehanlage. Die Vorrichtung umfasst dabei eine Basis, eine Klemmvorrichtung, die auf der Basis angeordnet ist, wobei die Klemmstruktur drehbar in einer vertikalen Ebene angeordnet ist

Das chinesische Gebrauchsmuster CN 21 548 141 1 U offenbart eine Kühl- und Transportvorrichtung für Silizium-Einkristalle mit großem Durchmesser. Die Kühl- und Transportvorrichtung für Siliziumeinkristalle mit großem Durchmesser umfasst ein Transportfahrzeug und eine Luftkühlungsbaugruppe, wobei das Transportfahrzeug eine Karosse, Stützbeine zum Stützen der Karosse und an den Unterseiten der Stützbeine angeordnete Rollen umfasst.

Das Patent US 452 397 2 A beschreibt eine Vorrichtung zum Entnehmen eines monokristallinen Stabes aus einem Kristallziehofen, wobei der Stab mit dafür geeigneten Backen gehalten wird.

Auch die Patentanmeldung EP 046 047 7 A1 offenbart eine Vorrichtung zur Entnahme eines gezüchteten Einkristallstabes aus den Einkristall-Ziehvorrichtungen und deren Beförderung zu einer vorbestimmten Position.

Das Patent US 4 350 560 A offenbart eine Vorrichtung und ein Verfahren zur Handhabung von gezüchteten Stäben aus einem Kristallzüchtungsofen, wobei die Vorrichtung und das Verfahren folgendes umfassen: Anheben und Bewegen einer oberen Kristallkammer mit dem darin getragenen Kristall zu einer Seite des Ofens; und sanftes Absenken des Kristalls in eine untere Kristallkammer, die unter der oberen Kristallkammer und auf einem Fahrzeug mit Rädern angeordnet ist, was eine einfache Entfernung und einen einfachen Transport von heißen schweren Kristallen mit minimaler Beschädigung oder Bruch ermöglicht.

Allen genannten Stellen im Stand der Technik gemein ist, dass ein gezogener Stab nicht automatisch ausgebaut werden kann wobei gleichzeitig ein zu jedem Zeitpunkt die Sicherheit gewährleistet ist, dass der Stab nicht abstürzt.

Aufgabe dieser Erfindung ist es daher ein Verfahren zur Verfügung zu stellen, das diesen Ansprüchen genügt.

Gelöst wird die Aufgabe durch die in den Ansprüchen beschriebenen Verfahren.

### Detaillierte Beschreibung der Erfindung

Beim Kristallziehen nach Czochralski wird ein Impfkristall in Kontakt mit der Schmelze gebracht und durch geeignete Steuerung der dem Fachmann bekannten Parameter ein als Dünnhals ("neck") bezeichneter Abschnitt gezogen, um Versetzungen zu beseitigen.

Anschließend wird ein konusförmiger Abschnitt des Kristalls (Anfangskonus) und schließlich ein zylindrischer Abschnitt des Kristalls gezogen, von dem später die Halbleiterscheiben abgetrennt werden. Am Ende wird der Kristall mit einem konusförmiger Abschnitt, dem Endkonus versehen, bevor der Kristall von der noch im Tiegel vorhandener Schmelze (Restschmelze) getrennt wird.

Das erfindungsgemäße Verfahren zum Ausbauen eines Kristalls aus einer Kristallziehanlage nach Czochralski umfasst folgende Schritte in gegebener Reihenfolge:
(a) Das Ziehen eines Kristalls in einer Ziehanlage nach Czochralski aus einer Kristallwachstumskammer in eine Kristallziehkammer, beinhaltend das Ziehen eines Dünnhalses.
(b) Das Abkühlen des gezogenen Kristalls in der Kristallziehkammer, die mit einer Kristallwachstumskammer verbunden ist. Dabei wird der gezogene Kristall vertikal so positioniert, dass er sich komplett im Bereich der Kristallziehkammer befindet.
(c) Das Abtrennen der Kristallziehkammer von der Kristallwachstumskammer durch Lösen der Verbindung zwischen Kristallziehkammer und Kristallwachstumskammer und Bewegen der Kristallziehkammer nach oben. Dabei wird sowohl die Kristallziehkammer zusammen mit dem darin befindlichen Kristall nach oben bewegt.

Bevorzugt wird nach dem Trennen der Kristallziehkammer und der Kristallwachstumskammer an der Unterseite der Kristallziehkammer eine erste Absturzsicherung so positioniert, dass der Kristall nicht mehr herausfallen kann. Bevorzugt wird vor dem Senken des Kristalls aus der Kristallziehkammer diese erste Absturzsicherung wieder entfernt.

Bevorzugt enthält die erste Absturzsicherung ein trichterförmiges Element enthaltend eine kreisrunde Öffnung in der Mitte und ein längliches Halteelement, das an dem einen Ende an dem trichterförmigen Element befestigt ist und an dem anderen Ende drehbar an der Kristallziehkammer befestigt ist.

Die erste Absturzsicherung ist dabei so konstruiert, dass das Positionieren durch Einschwenken und das Entfernen durch Ausschwenken erfolgen kann und die Mitte der runden Öffnung nach dem Einschwenken der Rotationsachse des Kristalls entspricht.
(d) Das horizontales Schwenken der Kristallziehkammer bis zu einer Endposition, so dass eine Kristalltransporteinheit den Kristall aufnehmen kann. Die Endposition des Schwenkens ist dabei so definiert, dass der Kristall nach dem Schwenken durch Senken genau in die Kristalltransporteinheit abgesenkt werden kann. Bevorzugt müssen dabei keine Korrekturen hinsichtlich der Position der Kristalltransporteinheit unternommen werden.

Bevorzugt positioniert sich die Kristalltransporteinheit automatisch selbstständig, so dass der Kristall sicher aufgekommen werden kann. Besonders bevorzugt ist die Kristalltransporteinheit so konstruiert, dass sie sich autonom bewegen kann.
(e) Das Senken des Kristalls aus der Kristallziehkammer in die Kristalltransporteinheit. Die Kristalltransporteinheit nimmt dabei den Kristall in vertikaler Position auf.

Bevorzugt wird während des Senkens des Kristalls aus der Kristallziehkammer in die Kristalltransporteinheit eine zweite bewegliche Absturzsicherung mit dem sich absenkenden Kristall mitgeführt, so dass zu keinem Zeitpunkt des Absenkens der Kristall unkontrolliert nach unten herausfallen kann. Die zweite bewegliche Absturzsicherung fährt dabei besonders bevorzugt in konstanter Geschwindigkeit parallel zum Kristall nach unten.

Ganz besonders bevorzugt wird die die Gewichtskraft des Stabes während des Absenkens gemessen. Die Gewichtskraft reduziert sich, sobald der Stand in Kontakt mit der Kristalltransporteinheit hat. Dieser Zeitpunkt wird benutzt, um den Absenkvorgang zu stoppen.

Die zweite bewegliche Absturzsicherung enthält dabei bevorzugt ein trichterförmiges Element, das eine kreisrunde Öffnung in der Mitte hat, das dazu geeignet ist, den Kristall im Falle eines Absturzes zu halten.

Hat der Kristall Kontakt mit der Kristalltransporteinheit, wird erfindungsgemäß der Kristalls am Dünnhals getrennt. Das Trennen wird dabei bevorzugt durch Abzwicken mittels eines dafür geeigneten Werkzeugs durchgeführt. Dem Fachmann sind hierfür geeignete Werkzeige bekannt.

Bevorzugt wird nach dem Trennen der Kristalls am Dünnhals der Kristall in der Kristalltransporteinheit in eine horizontale Position gebracht, so dass er in der Kristalltransporteinheit auf einer Kristalltrage zum Liegen kommt.

Die Kristalltrage ist dabei so ausgebildet, dass der Kristall in einer Mulde liegt, so dass er nicht wegrollen kann. Bevorzugt ist die Kristalltrage so ausgebildet, dass sie zusammen mit dem Kristall aus der Kristalltransporteinheit entnommen werden kann und der Kristall auf der Kristalltrage befestigt ist.

Besonders bevorzugt ist das Gewicht des Kristalls beim Ausbau größer als 200 kg.

Bevorzugt ist während des ganzen Vorganges der Stab umschlossen, um eine Gefährdung durch abplatzende Bruchstücke aus Silizium zu minimieren.

## Patentansprüche

1. Verfahren zum Ausbauen eines Kristalls aus einer Kristallziehanlage nach Czochralski umfassend folgende Schritte in gegebener Reihenfolge:
(a) Ziehen eines Kristalls in einer Ziehanlage nach Czochralski aus einer Kristallwachstumskammer in eine Kristallziehkammer, beinhaltend das Ziehen eines Dünnhalses,
(b) Abkühlen des gezogenen Kristalls in der Kristallziehkammer,
(c) Trennen der Kristallziehkammer von der Kristallwachstumskammer durch Lösen der Verbindung zwischen Kristallziehkammer und Kristallwachstumskammer und Verfahren der Kristallziehkammer nach oben,
(d) horizontales Schwenken der Kristallziehkammer bis zu einer Endposition, so dass eine Kristalltransporteinheit den Kristall aufnehmen kann,
(e) Senken des Kristalls aus der Kristallziehkammer in die Kristalltransporteinheit,
(f) Trennen des Kristalls am Dünnhals.

2. Verfahren nach Anspruch 1, **dadurch gekennzeichnet, dass** nach dem Trennen der Kristalls am Dünnhals der Kristall in der Kristalltransporteinheit in eine horizontale Position gebracht wird.

3. Verfahren nach Anspruch 2, **dadurch gekennzeichnet, dass** der Kristall in der Kristalltransporteinheit auf einer Kristalltrage zum Liegen kommt, die so gestaltet ist, dass sie zusammen mit dem Kristall aus der Kristalltransporteinheit entnehmbar ist.

4. Verfahren nach Anspruch 1 oder 2, **dadurch gekennzeichnet, dass** nach dem Trennen der Kristallziehkammer und der Kristallwachstumskammer an der Unterseite der Kristallziehkammer eine erste Absturzsicherung so positioniert wird, dass der Kristall nicht mehr herausfallen kann und dass vor dem Senken des Kristalls aus der Kristallziehkammer diese erste Absturzsicherung wieder entfernt wird.

5. Verfahren nach einem der vorigen Ansprüche, **dadurch gekennzeichnet, dass** während des Senkens des Kristalls aus der Kristallziehkammer in die Kristalltransporteinheit eine zweite bewegliche Absturzsicherung mit dem sich absenkenden Kristall mitgeführt wird, so dass zu keinem Zeitpunkt des Absenkens der Kristall unkontrolliert herausfallen kann.

6. Verfahren nach einem der vorigen Ansprüche, **dadurch gekennzeichnet, dass** sich die Kristalltransporteinheit automatisch selbstständig so positioniert, dass der Kristall sicher aufgekommen werden kann.

7. Verfahren nach Anspruch 4, **dadurch gekennzeichnet, dass** die erste Absturzsicherung folgende Elemente enthält
(a) ein trichterförmiges Element enthaltend eine kreisrunde Öffnung in der Mitte
(b) ein längliches Halteelement, das an dem einen Ende an dem trichterförmigen Element befestigt ist und an dem anderen Ende drehbar an der Kristallziehkammer befestigt ist,
so dass das Positionieren der ersten Absturzsicherung durch Einschwenken und das Entfernen durch Ausschwenken erfolgen kann und die Mitte der runden Öffnung nach dem Einschwenken der Rotationsachse des Kristalls entspricht.

8. Verfahren nach Anspruch 5, **dadurch gekennzeichnet, dass** die zweite bewegliche Absturzsicherung ein trichterförmiges Element, das eine kreisrunde Öffnung in der Mitte hat, enthält.

9. Verfahren nach Anspruch 1, **dadurch gekennzeichnet, dass** der Kristall ein Gesicht von mehr als 200 kg hat.

10. Verfahren nach Anspruch 1, **dadurch gekennzeichnet, dass** die Kristalltransporteinheit sich autonom bewegt.
